# EUROPEAN PATENT APPLICATION

(11) **EP 0 598 555 A1**
(43) Date of publication of application: **25.05.1994**
(21) Application number: 93309001.1
(22) Date of filing: 11.11.1993
(51) Int. Cl.: H01L 21/60, H01L 23/485

(54) **Process for forming input/output bumps**

(30) Priority: 17.11.1992 US 977362
(71) Applicant: AT&T Corp., New York, NY 10013-2412 (US)
(72) Inventor: Doherty, Charles John, Westfield, New Jersey 07090 (US); Kossives, Dean Paul, Glen Gardener, New Jersey 08826 (US); Nijander, Casimir Roman, Lawrenceville, New Jersey 08648 (US); Wong, Yiu-Man, Wescosville, Pennsylvania 18106 (US)
(74) Representative: Johnston, Kenneth Graham

(57) **Abstract**

Input/output bumps (15) are fabricated with a fine pitch using a negative resist (7) and a lift off. The resist is typically relatively thin and is patterned using radiation that is substantially absorbed in a surface layer. This absorption produces a hardened surface layer which facilitates the lift-off process.

## Description

### Technical Field

This invention relates generally to a method for forming input/output contacts to an integrated circuit and, particularly, to such a method that uses a resist lift-off.

### Background of the Invention

Integrated circuits must be electrically contacted. As is well known, an integrated circuit has a plurality of devices fabricated on a common substrate. As might be expected, several approaches have been pursued in attempts to expediently contact integrated circuits. At present, the most commonly used approach is wire bonding. This approach is presently limited to peripherally located input/output contacts. One version of wire bonding is tape automated bonding which permits the making of contacts to devices having finer pitch leads than would otherwise be attainable.

For many applications, devices in a two-dimensional array area must be contacted. For small arrays, the number of contacts is not enormous and peripheral contacts can be used. However, when the array becomes of even modest size, such as 128 x 128, peripheral contacts are difficult to implement and another approach, termed *flip chip bump bonding,* becomes more attractive. The name describes the process: electrically conducting bumps, which will be the I/O contacts, are formed on the same side of the chip as is the integrated circuit. A resist is deposited and patterned to form windows, metal is deposited, and the resist is lifted off leaving metal bumps. See, for example, *IBM Journal of Research and Development, July* *1980, pp. 452-460,* for a general description of the process. The chip is then flipped and mounted on a substrate which has an electrically conducting pattern that suitably mates with the bumps. This technology is commonly referred to as *controlled* *collapse chip connection.*

Although flip chip bonding is conceptually simple, successful implementation demands that consideration be given to several factors. For example, there are physical factors such as thermal and mechanical resistance to stress; material factors such as the selections of base metal and solder; and process factors such as selection of resist for patterning and method of metal deposition. Implicit in the above is the consideration that any successful implementation satisfy yield, reliability, and cost standards.

Typical integrated circuit bump bonding has a 250µm pitch between solder bumps with a diameter of about 125µm. The bump height is typically between 50µm and 75µm to satisfy thermal fatigue requirements. Typical metals used include Cr/Cu/Au and Pb/Sn for the base metals and solder bumps, respectively. The mask process may be either resist or metal mask. Deposition methods include sputtering, evaporation, and plating.

Some types of integrated circuits impose more stringent requirements on bump bonding than do other types. For example, there are devices called quantum well infrared photodetectors which are commonly referred to by the acronym QWIP. Such devices are used in imaging applications. For good spatial resolution, the pixel size should be small. QWIPs are fabricated in a 2-dimensional array rather than in a 1-dimensional linear array because the linear type of array demands stringent stability of the high-speed scanning mechanisms used in image processing. These and other requirements dictate the desirability of a pitch of 50µm, a diameter of 25µm, and a height of 12.5µm. These requirements can not be easily satisfied with a metal shadow mask and a spin-on resist or techniques used in printed circuit board fabrication. A thick resist is very difficult to pattern because the windows in the resist have a very high aspect ratio which makes development difficult. A thin resist, such as a spin-on resist, is difficult to use because the bump height will be limited to about half of the resist thickness.

### Summary of the Invention

Electrical input/output contacts are made to a plurality of regions on an integrated circuit by fabricating the integrated circuit on a wafer; forming a layer of negative resist on the integrated circuit; and patterning the layer of resist to produce a plurality of windows having re-entrant angles. The patterning produces a hardened surface layer of resist due to absorption of radiation in this layer. A layer of metal is deposited after patterning and the resist is lifted off. In a preferred embodiment, the negative resist comprises a dry resist which typically has a thickness of at least 15µm. In another preferred embodiment, the radiation has a wavelength shorter than about 356 nm. In still another embodiment, the metal comprises indium. In yet another embodiment, re-entrant angles are produced in the resist by selecting the wavelength of the radiation to produce a hardened surface layer.

In an exemplary embodiment, the integrated circuit has a plurality of photodetectors which are, for example, quantum well photodetectors.

### Brief Description of the Drawing

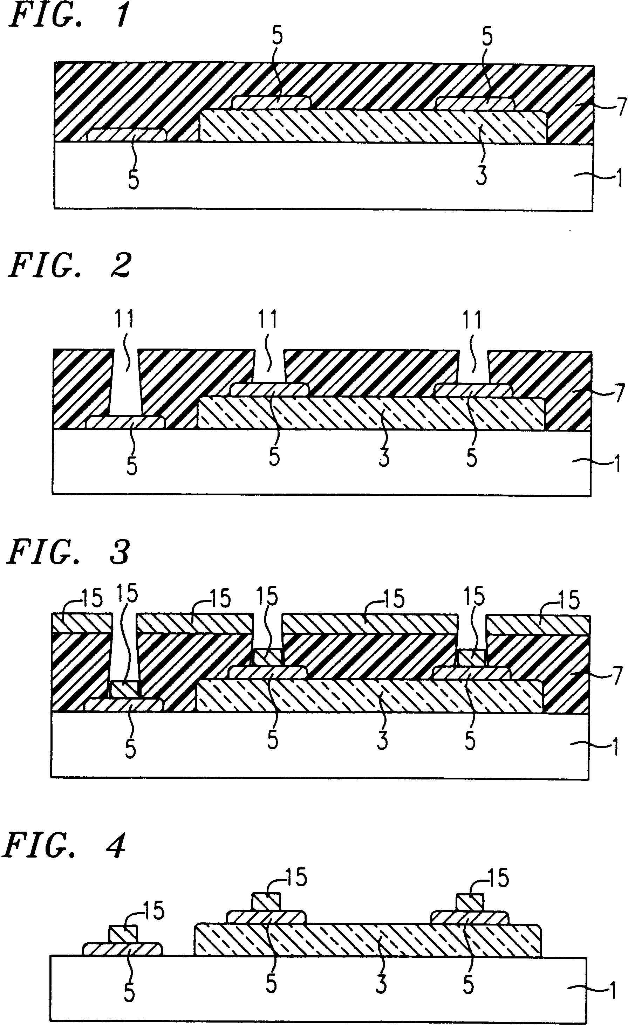

FIGs. 1-4 are sectional views of the integrated circuit being contacted which are useful in explaining the method of this invention.

For reasons of clarity, the elements depicted are not drawn to scale.

### Detailed Description

An exemplary embodiment of the invention will be described in detail. Some variations of this embodiment will also be mentioned; still others will be apparent to those skilled in the art.

FIG. 1 is a sectional view showing GaAs wafer 1 which may be mounted on a silicon wafer which is not shown. The silicon wafer is used only to facilitate handling of the GaAs wafer, and it need not be used. At least one integrated circuit has been fabricated on the top surface of wafer 1. The wafer has been patterned to form a mesa 3. There is a plurality of regions 5, on the GaAs wafer 1, including the mesa, which will be electrically contacted. A layer 7 of a negative resist has been deposited on the exposed surface of the wafer. Although the surface of the layer is shown as being planar, it typically will, to some extent, follow the contour of the wafer 1 and mesa 3.

Wafer 1 has at least one integrated circuit fabricated on its surfaces. In an exemplary embodiment, the circuit comprises a plurality of multiple quantum well photodetectors. Such detectors are well known, as is their fabrication. The regions 5 for electrical contacts to the photodetectors are typically approximately 50µm apart.

Although the structure depicted in FIG. 1 is generally made with well-known techniques, several aspects of the fabrication technique are not well known and deserve comment. The structure has been described in terms of wafers; it has been found that better cleanliness is obtained if the wafers are scribed and cleaned prior to bump bonding. Scribing and cleaning after formation of the bumps has been found to produce debris, typically having dimensions of at least 1 µm in size, which cannot be easily removed without damaging the bumps. The presence of the debris adversely affects the planarity of the bonding process and also that of the subsequently deposited resist. The negative resist, which is typically dry, may be deposited by lamination; such a dry resist is marketed by DuPont under the trademark of RISTON. Such films may be developed, depending upon their nature, in either a solvent-based developer or a sodium-carbonate solution. The latter is presently preferred for reasons which include safety and environmental considerations. A resist thickness of approximately 15µm is suitable. It is well known that the GaAs chips are extremely brittle. The resist should be laminated with optimized pressure to avoid chip breakage. A pressure of about 12.5 pounds/in² has been found useful. The scribed wafers survive the resist deposition process.

The resist is now patterned to form openings 11 which expose at least portions of the regions 5 which are to be contacted. The patterning is by exposing selected portions of the resist to radiation which produces a cross-linked or hardened surface layer. The resist development will produce openings 11 with re-entrant angles; that is, the opening should be smaller at the top than it is at the bottom. It has been found desirable to wait for a period of 30 to 60 minutes after exposure before beginning development. Appropriate developers or etchants will be readily selected by those skilled in the art. A high flow rate spin developer is used. The inclination of the nozzle with respect to the wafer depends on the spin speed of the wafer. The size of the re-entrant angle will depend upon the flow rate and the angle of inclination. The resulting structure is depicted in FIG. 2.

The wavelength of the radiation used for the exposure has been found to be important in obtaining the desired re-entrant angle. The wavelength should be selected so that the radiation will be absorbed in a surface layer of the resist; ideally no radiation.should be reflected from the substrate surface. That is, as mentioned, a cross-linked surface layer is produced. Such reflected radiation is scattered into regions adjacent to the desired opening and then absorbed. This makes formation of the re-entrant angles in the resist significantly more difficult and non-reproducible. However, when radiation is absorbed in a surface layer, formation of re-entrant angles is facilitated. When development starts, the non-cross-linked regions under the surface layer are susceptible to removal by the developer. Selection of wavelength depends upon resist thickness and the wavelength dependent absorption coefficient of the resist. The latter, of course, depends upon the resist. It has been found that the absorption coefficient of the RISTON resist used increases abruptly for wavelengths shorter than 350 nm. Shorter wavelengths are thus critical to obtaining proper resist exposure and re-entrant angles. Note that these wavelengths are shorter than the lines from a mercury lamp commonly used in lithography at the present time. Those skilled in the art will select a suitable wavelength.

For example, light with wavelengths of 405 nm and 365 nm (from a Hg lamp) has an absorption length in RISTON of 12µm. These lines must be excluded from the exposure because there would be too much substrate reflection from a 15µm thick resist. It has been found that the 310 and 320 nm lines, with filters to remove the 405 and 365 nm lines, and a 15µm thick resist combination yields excellent results because the top portion of the resist is strongly exposed (cross linked or polymerized) and the bottom portion of the resist is barely exposed. Over-development opens the bottom of the window more relative to the top of the window and forms re-entrant angles.

Metal is now deposited and the structure depicted in FIG. 3 is produced. For low temperature operation of QWIPs, a suitable metal is indium. It is desirable to cool the substrate to liquid nitrogen temperature for metal deposition. The low temperature increases the sticking coefficient of indium. At room temperature, some indium atoms do not stick to the substrate and are absorbed on the resist walls thereby forming crystal whiskers. The indium bump on the substrate is then undesirably rough and lift-off is very difficult because the whiskers may touch the bump. Appropriate deposition techniques for other applications will be readily selected by those skilled in the art. As will be readily appreciated, the amount of metal deposited should yield indium bumps of the appropriate height. The bump height may be less than the resist thickness so that portions of the resist surface forming the windows are left exposed. However, bump heights greater than the resist thickness may be obtained. The In grows primarily in the vertical direction. Bumps 20µm high on a 15µm thick resist were obtained. Lift-off was possible because the resist was not completely covered. This facilitates the development process and the subsequent lift-off. The lift-off will be readily performed by those skilled in the art. The resulting structure is depicted in FIG. 4.

Variations in the embodiments described will be apparent to those skilled in the art. For example, CMOS circuits used for low-temperature operation may be processed according to this invention.

## Claims

1. A method of fabricating electrical contacts 15 to an integrated circuit comprising the steps of:
fabricating an integrated circuit on a wafer 1;
forming a layer of negative dry resist 7 on said integrated circuit;
patterning said layer of resist 7 to produce a plurality of windows 11 having re-entrant angles, said patterning comprises exposing selected portions of said dry resist 7 to radiation, said radiation producing a hardened surface layer of said dry resist 7;
depositing a layer 15 of metal; and
lifting off said layer of dry resist 7.

2. A method as recited in claim 1 comprising the further steps of scribing and cleaning said wafer 1 before forming said layer of dry resist 7.

3. A method as recited in claim 2 in which said negative dry resist 7 is at least 15µm thick.

4. A method as recited in claim 2 in which said radiation has a wavelength shorter than 350 nm.

5. A method as recited in claim 4 in which said patterning comprises the step of developing said dry resist 7, said developing step being performed at least approximately 30 minutes after said exposing step.

6. A method as recited in claim 1 in which said depositing is at liquid nitrogen temperatures.

7. A method as recited in claim 6 in which said metal 15 comprises indium.

8. A method as recited in claim 7 in which said integrated circuit comprises a plurality of photodetectors.

9. A method as recited in claim 8 in which said photodetectors comprise quantum well photodetectors.

10. A method of fabricating re-entrant angles in a dry resist 7 comprising the steps of:
forming a layer of negative dry resist 7 on a wafer 1;
patterning said layer of resist to produce a plurality of windows 11 having re-entrant angles, said patterning comprises exposing selected portions of said dry resist 7 to radiation, said radiation having a wavelength which produces a hardened surface layer by absorption surface.

11. A method as recited in claim 9 in which said patterning comprises developing said dry resist 7 with a spin developer.
